Europäisches Patentamt

European Patent Office

Office européen des brevets

(19)

(11) Veröffentlichungsnummer: **0 271 601 B1**

(12) **EUROPÄISCHE PATENTSCHRIFT**

(45) Veröffentlichungstag der Patentschrift: **17.07.91**

(51) Int. Cl.⁵: **G01C 19/64,** H03D 1/06

(21) Anmeldenummer: **86117743.4**

(22) Anmeldetag: **19.12.86**

(54) Synchron-Demodulator mit digitaler Signalausgabe.

(43) Veröffentlichungstag der Anmeldung:
**22.06.88 Patentblatt 88/25**

(45) Bekanntmachung des Hinweises auf die
Patenterteilung:
**17.07.91 Patentblatt 91/29**

(84) Benannte Vertragsstaaten:
**BE DE ES FR GB IT NL SE**

(56) Entgegenhaltungen:
**EP-A- 0 168 292**
**DE-A- 3 140 110**
**DE-A- 3 233 829**
**US-A- 4 456 376**

**PATENT ABSTRACTS OF JAPAN, Band 6, Nr.
72 (E-105)[950], 7. Mai 1982;& JP - A - 57
001506 (OKI DENKI KOGYO) 20.01.1982**

**ELECTRONICS LETTERS, Band 19, Nr. 23,
10.November 1983, Seiten 997-999; K. BÖHM
et al.: "Direct rotation-rate detection with a
fibre-optic gyro by using digital data processing"**

(73) Patentinhaber: **LITEF GmbH**
**Lörracher Strasse 18**
**W-7800 Freiburg/Br.(DE)**

(72) Erfinder: **Schröder, Werner, Dr.**
**Vogtstrasse 5**
**W-7834 Blechheim(DE)**

(74) Vertreter: **TER MEER - MÜLLER - STEINMEI-
STER & PARTNER**
**Mauerkircherstrasse 45**
**W-8000 München 80(DE)**

## Beschreibung

In der Meßtechnik, der Steuer- und Regelungstechnik ergibt sich in einigen Bereichen die Notwendigkeit, das Meßsignal, beispielsweise ein Signal höherer Frequenz über einen großen dynamischen Bereich von beispielsweise fünf oder sieben Dekaden zu demodulieren. Als Beispiel für Meßsignale mit so großem Dynamikbereich seien sogenannte Faserkreisel erwähnt, deren Ausgangssignal hinsichtlich der Amplitude einer oder mehrerer Frequenzkomponenten mit hoher Genauigkeit über einen sehr hohen Dynamikbereich zu messen ist.

Schwierigkeiten mit bekannten Synchrondemodulatoren und nachgeschaltetem Analog/Digital-Wandler (A/D-Wandler) ergeben sich daraus, daß übliche Demodulatoren einerseits bei höheren Signalamplituden nicht mehr linear arbeiten und daß andererseits bei sehr kleinen Signalen die Nullpunktstabilität nicht ausreicht.

Der mit Anspruch 1 gekennzeichneten Erfindung liegt damit die Aufgabe zugrunde, einen Synchron-Demodulator mit digitaler Signalausgabe zu schaffen, der sich durch einen sehr großen Dynamikbereich, hohe Linearität und Nullpunktstabilität auszeichnet.

Ein erfindungsgemäßer Synchron-Demodulator mit digitaler Signalausgabe enthält außer dem eigentlichen Synchron-Demodulator und einem A/D-Wandler einen dem eigentlichen Synchron-Demodulator vorgeschalteten Analogsummierer, der einerseits mit dem zu demodulierenden Eingangssignal und andererseits mit einem Regel- oder Rückstellsignal gleicher Frequenz beaufschlagt ist, das von einem digitalen Regler geliefert wird, der eingangsseitig mit dem Demodulator-Ausgangssignal beaufschlagt ist und einen Digital/Analog-Wandler (D/A-Wandler) synchron mit der Frequenz des zu demodulierenden Signals ansteuert und die auf den Analogsummierer geschaltete Ausgangsamplitude des D/A-Wandlers in diskreten Schritten so verändert, daß das Demodulator-Ausgangssignal im Mittel zu Null wird.

Der digitale Regler enthält vorzugsweise einen analogen, eingangsseitig mit dem Ausgang des Demodulators verbundenen Integrator, dessen Ausgangssignal den A/D-Wandler speist, und weiterhin einen mit dem digitalisierten Signal beaufschlagten Prozessor, der die einem Binärwert entsprechende Schwelle, die LSB-Schwelle (LSB = Least Significant Bit) prüft und bei sich ändernder Amplitude des Eingangssignals die Ausgangsamplitude des vom Prozessor angesteuerten D/A-Wandlers stufenweise mit dem Ziel nachstellt, das Eingangssignal des A/D-Wandlers unter der LSB-Schaltschwelle zu halten.

Mit dem erfindungsgemäßen rückstellenden Prinzip wird die bisher für Demodulatoren mit erforderlichem hohem Dynamikbereich gegebene Begrenzung (schlechte Linearität bei großen Signalamplituden und unbefriedigende Nullpunkt-Stabilität bei kleinen Signalen) dadurch umgangen, daß das Eingangssignal hinsichtlich einer sich ändernden Amplitude laufend überwacht und "rückgestellt" wird, um auf diese Weise zu erreichen, daß der Demodulator richtig abgestimmt immer um den Nullpunkt herum arbeitet, so daß mit stark vorverstärkten Signalen gearbeitet werden kann und die Nullpunkt-Stabilität des Demodulators dann die Gesamtgenauigkeit wesentlich weniger beeinflußt als dann, wenn das Eingangssignal direkt demoduliert werden muß.

Mit dem der Erfindung zugrundeliegenden Rückstellprinzip erhält man digitale Meßsignale, aus denen sich beispielsweise im Falle eines Faserkreisels in Open-Loop-Konfiguration mit Hilfe eines Rechners und unter Anwendung bekannter Algorithmen eine Drehrate laufend errechnen läßt bzw. es kann die Amplitude einer Phasenmodulation geregelt werden.

Die Erfindung und weitere vorteilhafte Einzelheiten werden nachfolgend unter Bezug auf die Zeichnung in einer beispielsweise Ausführungsform näher erläutert. Es zeigen:

Fig. I     den prinzipiellen Schaltungsaufbau eines erfindungsgemäßen Synchron-Demodulators mit digitaler Signalausgabe und hohem Dynamikbereich, und

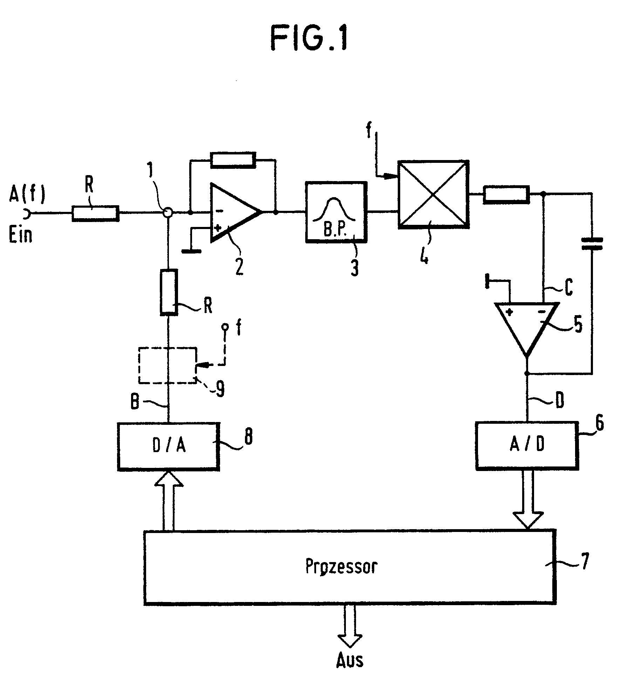

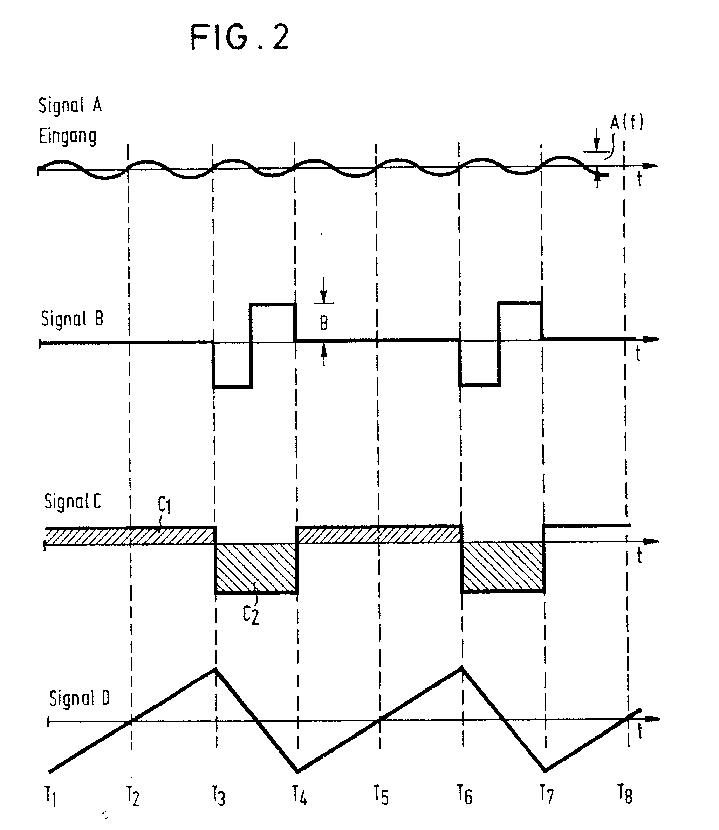

Fig. 2     ein Signaldiagramm zur Erläuterung der Arbeitsweise des Demodulators nach Fig. I.

Bei der Schaltung nach Fig. I wird am Summationspunkt I einerseits ein Signal $A \cdot \sin 2\pi f \cdot t$ und von einem Digital/Analog-Wandler (D/A-Wandler) 8 ein im allgemeinen intermittierendes Rechteck-Wechselsignal mit variabler Amplitude B und der Frequenz f so zugeführt, daß nach Summation in einem Summierer 2 und nach Demodulation in einem Synchrondemodulator 4 über eine Regelschleife, gebildet durch einen Integrator 5 einen Analog/Digital-Wandler (A/D-Wandler) 6 und einen Prozessor 7 am Summationspunkt I das (Hoch-)Frequenzsignal mit der Frequenz f im Zeitmittel zu (annähernd) Null wird. Ein zwischen dem Summierer 2 und dem Synchron-Demodulator 4 liegendes Bandpaßfilter 3 ist auf die Frequenz f abgestimmt. Statt den D/A-Wandler 8 das Rechteckwechselsignal erzeugen zu lassen, ist es auch möglich, ein Wechselsignal mit Hilfe eines Umpolers 9 zu erzeugen, wobei dann der D/A-Wandler die Amplitude des Wechselsignals liefert.

Die Rückstellung auf den durch die Auflösung des A/D-Wandlers 6 bestimmten Minimalwert erfolgt schrittweise durch einen iterativen Algorithmus, der bewirkt, daß die dem Integrator 5 durch die Spannung aus dem demodulierten Signal A·sin 2πf·t zugeführte Ladung im Mittel gleich der digitalisierten Ladung durch die Spannung B ist.

Die Funktionsweise der Schaltung wird nachfolgend unter Bezug auf die Fig. 2 erläutert.

Am Eingang liege ein Signal A der Frequenz f mit nur geringfügig schwankender, annähernd konstanter Amplitude A. Diesem Signal wird am Summationspunkt I entsprechend dem Auflösungsvermögen des D/A-Wandlers 8 im dargestellten Beispiel in jeder dritten Periode ein verhältnismäßig großes Signal B hinzugefügt. Während der dazwischenliegenden Perioden wird die Schaltschwelle des D/A-Wandlers 8 nicht überschritten, es erscheint also kein B-Signal. Das im Summierer 2 summierte Signal wird nach Bandfilterung im Demodulator 4 demoduliert und ergibt das in der dritten Zeile gezeigte Signal C, bei dem die Flächen $C_1$ und $C_2$ (annähernd) gleich sind, wobei im dargestellten Fall nur die DC-Anteile gezeigt sind. Das Signal C am Ausgang des Demodulators 4 gelangt auf den Integrator 5. Entsprechend dem Signal C zeigt das am Ausgang des bipolaren Integrators 5 erscheinende Signal D rampenförmigen Verlauf jeweils entsprechend dem Vorzeichen des Eingangssignals C. Das Integratorausgangssignal wird vom A/D-Wandler 6 in Digitalsignale umgesetzt, so daß der Prozessor 7 erkennen kann, wann eine ansteigende oder abfallende Rampe einen gewissen Schwellwert übersteigt. Ist der Schaltschwellwert des A/D-Wandlers 6 überschritten, so ergibt dies ein "Signal" für den Prozessor 7, die Amplitude B des D/A-Wandlers 8 jeweils um ein Bit herauf oder herunter zu setzen entsprechend dem Vorzeichen des intermittierenden rückstellenden Signals am Ausgang des A/D-Wandlers 6.

Die nachfolgende Tabelle veranschaulicht die Verhältnisse für ein Beispiel, bei dem der Effektivwert der Amplitude des Eingangssignals A = 0,33 mV beträgt. Die Auflösung des D/A-Wandlers 8 bzw. des A/D-Wandlers 6, also der LSB-Wert (LSB = Least Significant Bit) betrage I mV. Die nachfolgende Tabelle bezieht sich auf das Schaubild der Fig. 2.

## TABELLE

Annahme:  LSB des D/A-Wandlers 8: 1 mV

LSB des A/D-Wandlers 6: 1 mV

Taktzeit: T = 1/f

| Takt | A = Konst. | Ausgang B D/A-Wandler | Ausgang C Integrator | Bemerkungen |
|------|-----------|----------------------|---------------------|-------------|
| $T_1$ | $0,\overline{3}3$ mV | 0 mV | −1 mV | Annahme |
| $T_2$ | $0,\overline{3}3$ mV | 0 mV | 0 mV | |
| $T_3$ | $0,\overline{3}3$ mV | $-\overline{1}$ mV | +1 mV | C = 1 mV ≙ Schwelle ↑A/D-Wandler ↴ D/A-Amplitude wird um 1 Bit erhöht |
| $T_4$ | $0,\overline{3}3$ mV | 0 mV | −1 mV | C = −1 mV ≙ untere Schwelle ↓ des A/D-Wandlers ↴ D/A-Amplitude wird um 1 Bit erhöht |
| $T_5$ | $0,\overline{3}3$ mV | 0 mV | 0 mV | |

Für den Betrag der Amplitude des Signals B ergeben sich damit unter der Voraussetzung eines i-Bit D/A-Wandlers 8 bei bipolarem Betrieb $2^{(i-1)}$ Möglichkeiten oder Amplituden. D.h., es gilt

$$B = b \times 2^{(i-1)},$$

wobei mit b = LSB des D/A-Wandlers, z. B. LSB = 1 mV, bezeichnet ist.

Ersichtlicherweise ist die zur Rückstellung erforderliche Anzahl von (Rechteck)-Perioden gleich f pro Sekunde (einschließlich Rechteckperiode mit Amplitude 0).

Steigt das Eingangssignal beispielsweise um eine Dekade an, so liefert der Integrator 5 an den A/D-Wandler 6 ein u.U. über mehrere Perioden ansteigendes Rampensignal D. Der A/D-Wandler 6 teilt diese Information als Nachstellsignal an den Prozessor 7 mit, der wiederum den D/A-Wandler 8 um so viele Schritte nachstellt, wie dem Auflösungsvermögen des D/A-Wandlers 8 entspricht. Das Ausgangssignal B des D/A-Wandlers 8 beinhaltet gleichzeitig die Information über die Eingangsamplitude. Eine Möglichkeit zur Datenausgabe besteht darin, die vom Prozessor an den D/A-Wandler 8 abgegebenen digitalen Werte als Impulse direkt ausgeben zu lassen. Die Schaltung erfüllt damit auch die Funktion eines Spannungs/Frequenz-Wandlers.

Um eine möglichst "schnelle" Schaltung zu erzielen, ist es sinnvoll, die Schrittweite der D/A-Wandlerausgangsamplitudenänderung zu vergrößern, wenn die Eingangsamplitudenänderung am A/D-Wandler über den Taktzyklus groß ist. Eine Möglichkeit wäre, die Schrittweite gleich dem digitalisierten A/D-Wandlersignal zu machen, wobei OV Eingangsspannung Schrittweite "Null" und positive (bzw. negative) Eingangsspannung positive (bzw. negative) Schrittweite bedeuten.

Gegenüber herkömmlichen Synchron-Demodulatoren bietet die Erfindung vor allem folgende entscheidende Vorteile:

- Der Demodulator wird im Mittel nur mit sehr kleinen Signalen betrieben; Linearitätsprobleme sind also beseitigt.
- Die Verstärkungsstabilität des Bandfilters 3 und des Demodulators 4 spielen praktisch keine Rolle mehr.
- Der erfindungsgemäße Teil der Regelelektronik ist digital ausgelegt.
- Der A/D-wandelnde Demodulator zeichnet sich durch einen sehr großen Dynamikbereich aus.

Ein erfindungsgemäßer Synchron-Demodulator mit digitaler Signalausgabe eignet sich in besonderer Weise für Open-Loop-Faserkreisel.

## Patentansprüche

1. Synchron-Demodulator mit digitaler Signalausgabe mit
   - einem Analogsummierer (2), der einerseits mit dem zu demodulierenden Eingangssignal der Frequenz f und andererseits mit einem Regelsignal gleicher Frequenz beaufschlagt ist.
   - einem mit dem Ausgang des Analogsummierers (2) verbundenen analogen Synchron-Demodulator (4),
   - einem dem analogen Signal-Demodulator (4) nachgeschalteten analogen Integrator (5),
   - einem vom Integrator (5) gespeisten digitalen Regler, zu dem
     - ein Analog/Digital-Wandler (6),
     - ein mit dem Ausgang des Analog/Digital-Wandlers (6) verbundener Signalprozessor (7) und
     - ein vom Signalprozessor (7) angesteuerter bipolar wirkender Digital/Analog-Wandler (8), der mit der zu demodulierenden Frequenz f synchronisiert ist,
     gehören sowie mit
   - einer Verbindung vom Ausgang des bipolaren Digital/Analog-Wandlers (8) zum Regelsignaleingang des Analogsummierers (2).

2. Synchron-Demodulator nach Anspruch 1, **dadurch gekennzeichnet,** daß der Signalprozessor (7) die Ausgangsamplitude des Digital/Analog-Wandlers (8) derart regelt, daß das Signal am Eingang des Analog/Digital-Wandlers (6) im wesentlichen dem Betrage nach kleiner als eine vorgegebene Schaltschwelle (LSB-Wert) des Analog/Digital-Wandlers (6) bleibt.

3. Synchron-Demodulator nach Anspruch 1 oder 2, **dadurch gekennzeichnet,** daß das digitale Rückstellsignal des Signalprozessors (7) als Meßwert auslesbar ist.

4. Synchron-Demodulator nach Anspruch 1, **dadurch gekennzeichnet,** daß dem analogen Synchron-Demodulator (4) auf auf die zu demodulierende Frequenz abgestimmtes Bandpaßfilter (3) vorgeschaltet ist.

## Claims

4

# EP 0 271 601 B1

1. Synchronous demodulator with digital signal output, comprising
   - an analog adder (2) to which, on the one hand, the input signal of the frequency f to be demodulated and, on the other hand, a control signal of the same frequency is applied,
   - an analog synchronous demodulator (4) which is connected to the output of the analog adder (2),
   - an analog integrator (5) following the analog signal demodulator (4),
   - a digital controller fed by the integrator (5), belonging to which controller are
      - an analog/digital converter (6),
      - a signal processor (7) connected to the output of the analog/digital converter (6) and
      - a bipolar-action digital/analog converter (8), which is driven by the signal processor (7) and is synchronised with the frequency f to be demodulated,
   as well as comprising
   - a connection from the output of the bipolar digital/analog converter (8) to the control signal input of the analog adder (2).

2. Synchronous demodulator according to Claim 1, characterized in that the signal processor (7) controls the output amplitude of the digital/analog converter (8) in such a way that the signal at the input of the analog/digital converter (6) remains essentially less in amount than a predetermined switching threshold (LSB value) of the analog/digital converter (6).

3. Synchronous demodulator according to Claim 1 or 2, characterized in that the digital resetting signal of the signal processor (7) can be read out as measured value.

4. Synchronous demodulator according to Claim 1, characterized in that the analog synchronous demodulator (4) is preceded by a bandpass filter (3) which is tuned to the frequency to be demodulated.

**Revendications**

1. Démodulateur synchrone à sortie numérique comportant
   - un sommateur analogique (2), alimenté d'une part par le signal d'entrée â démoduler à la fréquence f et d'autre part par un signal de régulation de même fréquence,
   - un démodulateur synchrone analogique (4) relié à la sortie du sommateur analogique (2),
   - un intégrateur analogique (5) disposé en aval du démodulateur synchrone analogique (4),
   - un régulateur numérique alimenté par l'intégrateur (5), auquel appartiennent
      - un convertisseur analogique/numérique (6),
      - un processeur de signaux (7) relié à la sortie du convertisseur analogique/numérique (6) et
      - un convertisseur numérique/analogique à action bipolaire commandé par le processeur de signaux (7), qui est synchronisé sur la fréquence f à démoduler,
   - ainsi qu'une liaison entre la sortie du convertisseur numérique/analogique bipolaire (8) et l'entrée de signal de régulation du sommateur analogique (2).

2. Démodulateur synchrone selon la revendication 1, caractérisé en ce que le processeur de signaux (7) régule l'amplitude de sortie du convertisseur numérique/analogique (8) de telle sorte que le signal à l'entrée du convertisseur analogique/numérique (6) demeure à une amplitude sensiblement plus faible qu'un seuil de commutation prédéterminé (valeur LSB) du convertisseur analogique/numérique (6).

3. Démodulateur synchrone selon la revendication 1 ou 2, caractérisé en ce que le signal numérique de remise en position du processeur de signaux (7) est exploitable en tant que valeur de mesure.

4. Démodulateur synchrone selon la revendication 1, caractérisé en ce qu'en amont du démodulateur synchrone analogique (4) est disposé un filtre passe-bande (3) accordé sur la fréquence à démoduler.

# FIG.1

# FIG.2

Signal A
Eingang

A(f)

Signal B

B

Signal C

C1

C2

Signal D

T1    T2    T3    T4    T5    T6    T7    T8